(19) Europäisches Patentamt
European Patent Office
Office européen des brevets

(11) EP 2 832 777 A1

(12) EUROPEAN PATENT APPLICATION
published in accordance with Art. 153(4) EPC

(43) Date of publication:
**04.02.2015 Bulletin 2015/06**

(21) Application number: **13770385.6**

(22) Date of filing: **21.03.2013**

(51) Int Cl.:
***C08J 5/18*** *(2006.01)*
***B32B 27/20*** *(2006.01)*
***C08K 3/22*** *(2006.01)*
***H01L 31/042*** *(2014.01)*
***B32B 27/00*** *(2006.01)*
***C08K 3/04*** *(2006.01)*
***C08L 67/02*** *(2006.01)*

(86) International application number:
**PCT/JP2013/058031**

(87) International publication number:
**WO 2013/146516 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.03.2012 JP 2012073657**

(71) Applicant: **FUJIFILM Corporation**
**Tokyo 106-8620 (JP)**

(72) Inventor: **TAKEGAMI Ryuta**
**Fujinomiya-shi**
**Shizuoka 418-8666 (JP)**

(74) Representative: **Hoffmann Eitle**
**Patent- und Rechtsanwälte PartmbB**
**Arabellastraße 30**
**81925 München (DE)**

# (54) POLYMER SHEET, REVERSE-SIDE PROTECTIVE SHEET FOR SOLAR CELL, AND SOLAR CELL MODULE

(57) Surface shape defects in a polymer sheet having a visual transmittance of from 5% to 50% and a visual absorption of from 10% to 50% are easily recognized.

Fig. 1

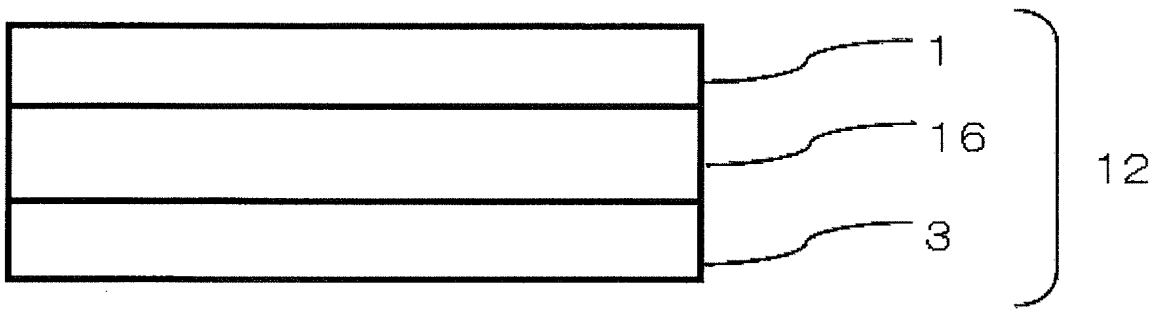


EP 2 832 777 A1

## Description

### Technical Field

The present invention relates to a polymer sheet, a back protective sheet for a solar cell, and a solar cell module.

### Background Art

A polymer sheet may be easily colored by kneading a dye (such as a colorant) or a pigment (such as scattering particles) thereinto or accumulating a layer containing a dye (such as a colorant) or a pigment (such as scattering particles) thereon, and thus is being used in various fields of art in recent years. The colored polymer sheet is used as a back protective sheet (i.e., a back sheet) for various solar cell modules, as described, for example, in Patent Literatures 1 to 6. A back protective sheet for a solar cell module is used on a back surface of a solar cell module, and a colored polymer sheet is used therefor from the standpoint of increasing the reflectance for enhancing the electric power generation efficiency by reflecting light passing through the solar cell.

### Citation List

### Patent Literatures

Patent Literature 1: JP-A-2010-519742
Patent Literature 2: JP-A-2007-150084
Patent Literature 3: JP-A-2006-270025
Patent Literature 4: JP-A-2011-29397
Patent Literature 5: JP-A-2011-165967
Patent Literature 6: JP-A-2011-184488

### Summary of Invention

### Technical Problem

However, the colored polymer sheet having the material composition may suffer in some cases surface shape defects, such as so-called thickness unevenness, fisheyes and die lines, while it is demanded to have uniformity. In particular, a back protective sheet for a solar cell module may be simultaneously demanded to have such capabilities as durability (such as hydrolysis resistance and electric insulating property) and adhesiveness to a Si cell sealant, but surface shape defects occurring may adversely affect these capabilities, and it is strongly demanded to enable recognition of occurrence of surface shape defects.
However, it is the current situation that it is difficult to recognize visually the occurrence of surface shape defects in the colored polymer sheet having been ordinarily used.
The invention has been made in view of the circumstances, and a problem to be solved by the invention is to provide a polymer sheet, surface shape defects of which may be easily recognized.

### Solution to Problem

As a result of earnest investigations made by the inventors for solving the problem, it has been found that surface shape defects may be easily recognized by controlling the visual transmittance and the visual absorption of the polymer sheet to particular ranges.
The invention as specific measures for solving the problem is as follows.

[1] A polymer sheet having a visual transmittance and a visual absorption that satisfy the following expressions (1) and (2):

$$5\% \leq (\text{visual transmittance}) \leq 50\% \quad (1)$$

$$10\% \leq (\text{visual absorption}) \leq 50\% \quad (2)$$

[2] The polymer sheet according to the item [1], which is preferably a back protective sheet for a solar cell.
[3] The polymer sheet according to the item [1] or [2], wherein the polymer sheet preferably contains a binder containing an organic polymer, an inorganic polymer or an organic-inorganic hybrid polymer, a colorant and scattering particles in one layer, and the layer containing the binder, the colorant and the scattering particles preferably has a content W1 of the colorant and a content W2 of the scattering particles that satisfy the following expression (3):

$$1,000 \leq W2/W1 \leq 30,000 \quad (3)$$

wherein W1 represents the content (% by mass) of the colorant with respect to the binder, and W2 represents the content (% by mass) of the scattering particles with respect to the binder.
[4] The polymer sheet according to any one of the items [1] to [3], wherein the colorant is preferably carbon black.
[5] The polymer sheet according to any one of the items [1] to [4], wherein the scattering particles are preferably titanium dioxide.
[6] The polymer sheet according to any one of the items [1] to [5], wherein the polymer sheet is preferably a laminate having two or more layers.
[7] The polymer sheet according to any one of the items [1] to [6], wherein the polymer sheet preferably further contains a polymer support.
[8] The polymer sheet according to any one of the items [1] to [7], wherein the polymer sheet preferably further contains a white layer containing a white pigment.
[9] The polymer sheet according to any one of the items [1] to [8], wherein the polymer sheet preferably has a difference in visual reflectance between front and back surfaces thereof of 3% or more.
[10] A solar cell module containing the polymer sheet according to any one of the items [1] to [9] as a back protective sheet for a solar cell module.

Advantageous Effects of Invention

According to the invention, a polymer sheet may be provided, surface shape defects of which may be easily recognized. According to the polymer sheet of the invention, the surface shape defects thereof may be easily recognized, and in the production of a solar cell module using the polymer sheet of the invention as a back protective sheet for a solar cell module, such a solar cell module may be provided that has a small appearance failure rate.

Brief Description of Drawings

[Fig. 1] Fig. 1 is a schematic view showing an example of a cross section of a polymer sheet according to the invention.
[Fig. 2] Fig. 2 is a schematic view showing an example of a cross section of a solar cell module using a polymer sheet according to the invention as a back protective sheet for a solar cell module.

Description of Embodiments

The polymer sheet of the invention, the back protective sheet for a solar cell module using the polymer sheet of the invention, and the solar cell module will be described in detail below.
The description for the constitutional components shown below may be made with reference to representative embodiments of the invention, but the invention is not limited to the embodiments. In the description, a numerical range expressed by "from X to Y" means a range including the numerals X and Y as the lower limit and the upper limit, respectively.

Polymer Sheet

The polymer sheet of the invention has a visual transmittance and a visual absorption that satisfy the following expressions (1) and (2):

$$5\% \leq (\text{visual transmittance}) \leq 50\% \quad (1)$$

$$10\% \leq (\text{visual absorption}) \leq 50\% \quad (2)$$

Characteristics

Optical Density

The polymer sheet of the invention has an optical density that satisfies the expressions (1) and (2), and thereby surface shape defects thereof may be easily recognized. The polymer sheet that has the optical density has not been known in the art.

Visual Transmittance

Surface shape defects may be effectively found out with transmitted light by viewing the polymer sheet over a light source having an ordinary luminance. When the visual transmittance of the polymer sheet is 5% or more, surface shape defects may be easily viewed due to a sufficient amount of the transmitted light. When the visual transmittance of the polymer sheet is 50% or less, the surface shape may be examined with transmitted light due to the sufficient gradation thereof.

The polymer sheet of the invention preferably has a visual transmittance of from 5 to 25%, and more preferably from 5 to 18%.

Visual Absorption

Surface shape defects may also be effectively found out with absorption unevenness of transmitted light due to the colorant of the polymer sheet, and when the visual absorption is 10% or more, surface shape defects may be viewed due to the sufficiently large coloration amount. When the visual absorption of the polymer sheet is 50% or less, the surface shape may be examined due to the sufficient gradation thereof.

The polymer sheet of the invention preferably has a visual absorption of from 10 to 30%, and more preferably from 12 to 26%.

Difference in Visual Reflectance

In a preferred embodiment of the polymer sheet of the invention, the polymer sheet may have good discriminability between front and back surfaces thereof.

While not sticking to any theory, the visual reflectance may be differentiated between the front and back surfaces, thereby improving the discriminability between the front and back surfaces of the polymer sheet. The polymer sheet of the invention preferably has a difference in visual reflectance between the front and back surfaces thereof of 3% or more, more preferably 5% or more, and particularly preferably 11% or more.

The polymer sheet of the invention having the configuration may have good discriminability between the front and back surfaces of the sheet, and for example, in the production process of a solar cell module using the polymer sheet of the invention as a back protective sheet for a solar cell module, the front and back surfaces of the polymer sheet may be visually discriminated from each other in a short period of time even when the polymer sheet is fallen down, and the identification of the front and back surfaces is lost. Accordingly, the use of the polymer sheet of the invention as a back protective sheet for a solar cell module enhances the production efficiency of the solar cell module.

The polymer sheet of the invention preferably has a visual reflectance of the surface that has the lower visual reflectance between the front and back surfaces of from 40 to 90%, more preferably from 50 to 90%, and particularly preferably from 60 to 90%.

Layer Structure

The polymer sheet of the invention preferably contains the binder, the colorant and the scattering particles in one layer. The structure may facilitate the control of the optical density to the above range. On scattering light incident on the polymer sheet of the invention with the scattering particles, the light is scattered in the layer while being absorbed by the colorant, and then emitted outside the polymer sheet, and thus the visual absorption of the polymer sheet may

be sufficiently controlled to the preferred range with a small amount of the colorant.

The polymer sheet of the invention may be a sheet containing only one layer or a laminate having two or more layers, and is preferably a laminate having two or more layers.

In the case where the polymer sheet of the invention is a laminate having two or more layers, the polymer sheet more preferably contains at least a polymer support, and the layer containing a binder, a colorant and scattering particles.

The polymer sheet of the invention further preferably contains, in addition to the layer containing a binder, a colorant and scattering particles, a white layer containing a white pigment from the standpoint of controlling the optical density to the preferred range and the standpoint of enhancing the discriminability between the front and back surfaces thereof.

The polymer sheet of the invention preferably contains a binder containing an organic polymer, an inorganic polymer or an organic-inorganic hybrid polymer, a colorant and scattering particles in one layer, and the layer containing the binder, the colorant and the scattering particles preferably has a content W1 of the colorant and a content W2 of the scattering particles that satisfy the following expression (3) :

$$1{,}000 \leq W2/W1 \leq 30{,}000 \quad (3)$$

wherein W1 represents the content (% by mass) of the colorant with respect to the binder, and W2 represents the content (% by mass) of the scattering particles with respect to the binder.

The value W2/W1 is more preferably from 1,000 to 10,000, and particularly preferably from 1,000 to 5,000.

The polymer sheet of the invention is preferably a back protective sheet for a solar cell.

A preferred structure of the polymer sheet of the invention is shown in Fig. 1. The polymer sheet shown in Fig. 1 contains a polymer support 16 having provided one surface thereof a layer 3 containing a binder, a colorant and scattering particles, and having provided on the other surface thereof a white layer 1.

Fig. 2 schematically shows an example of the polymer sheet of the invention and the solar cell module of the invention in the case where the polymer sheet of the invention is used as a back protective sheet for a solar cell module. The polymer sheet in this embodiment contains a polymer support 16 having provided one surface thereof, as a weather resistant layer 3, a layer containing a binder, a colorant and scattering particles, and having provided on the other surface thereof (i.e., the solar light incident surface) a white layer 1.

In a solar cell having a laminated structure, transparent front substrate/device structure/back sheet, containing a transparent substrate disposed on the solar light incident surface (i.e., a front substrate, such as a glass substrate), a device structure (including a solar cell device and a sealant that seals the device) and a back sheet for a solar cell, the polymer sheet of the invention may be applied to the back sheet. The back sheet herein is a back protective sheet that is disposed on the side where the front substrate is not disposed with respect to the substrate of the cell of the device structure.

The solar cell module 10 in Fig. 2 is constituted by disposing a solar cell device 20 converting light energy of the solar light to electric energy between the solar light incident transparent substrate 24 and the polymer sheet 12 of the invention having been described, and sealing the substrate and the polymer sheet 12 with an ethylene-vinyl acetate sealant 22.

The layers of the polymer sheet of the invention will be described in detail below with reference to an embodiment where the polymer sheet of the invention is used as a back protective sheet for a solar cell module. However, the polymer sheet of the invention is not limited to the following embodiment where it is used as a back protective sheet for a solar cell module.

## Polymer Support

The polymer sheet of the invention preferably contains a polymer support.

The polymer sheet of the invention may contain the colorant and the scattering particles in the polymer support and preferably contains them in a layer other than the polymer support from the standpoint of facilitating the control of the optical density to the preferred range. In the case as described above where the polymer support contains the scattering particles, and the colorant is contained in a weather resistant layer described later, the value W2 is calculated as the content of the scattering particles in the polymer support with respect to the binder (such as PET) of the polymer support, and the value W1 is calculated from the content of the colorant in the weather resistant layer described later with respect to the binder of the weather resistant layer.

In the description herein, among both the surfaces of the polymer support, the surface having the weather resistant layer described later to be laminated may be referred to as a surface A, and the surface having the white layer described later to be laminated may be referred to as a surface B.

The thickness of the polymer support (particularly a polyester substrate) is not particularly limited, and is preferably from 145 to 300 μm, more preferably from 180 to 270 μm, and further preferably from 210 to 250 μm, from the standpoint of the enhancement of the hygrothermal durability of the adhesiveness.

In recent years, a back sheet for a solar cell is demanded to be improved in electric insulation property associated with the increase of the output power of the solar cell. In general, the electric insulation property is proportional to the thickness of the back sheet, and thus a thicker back sheet is being demanded. In view of the demand, the back protective sheet for a solar cell may have good electric insulation property by making the thickness of the polymer support to the aforementioned preferred range.

Examples of the polymer support include substrates formed of a polyester, a polyolefin, such as polypropylene and polyethylene, and a fluorine polymer, such as polyvinyl fluoride. The substrate may be in the form of a film or a sheet. Among these, in the polymer sheet of the invention, the polymer support is preferably a polyester support from the standpoint of the cost and the mechanical strength.

The polyester substrate used as the polymer support (support) in the invention may be a linear saturated polyester that is synthesized from an aromatic dibasic acid or an ester-forming derivative thereof and a diol or an ester-forming derivative thereof. Specific examples of the polyester include films or sheets of polyethylene terephthalate, polyethylene isophthalate, polybutylene terephthalate, poly(1,4-cyclohexylene dimethylene terephthalate) and polyethylene 2,6-naphthalate. Among these, polyethylene terephthalate and polyethylene 2,6-naphthalate are particularly preferred in view of the balance of the mechanical properties and the cost.

The polyester substrate may be a homopolymer or a copolymer, and may be a mixture of the polyester and another resin, such as a polyimide in a small amount.

On polymerizing the polyester in the invention, Sb series, Ge series and Ti series compounds are preferably used as a catalyst from the standpoint of suppressing the carboxyl group content to the prescribed range, and among these, a Ti series compound is particularly preferred. In the case where a Ti series compound is used, such an embodiment is preferred that the polymerization is performed by using a Ti compound as a catalyst in an amount in terms of Ti element of from 1 to 30 ppm, and more preferably from 3 to 15 ppm. When the amount of the Ti compound used is in the range in terms of Ti element, the terminal carboxyl group may be controlled to the range described later, thereby maintaining the hydrolysis resistance of the polymer support high.

For the synthesis of the polyester compound using a Ti compound, such methods may be applied as those described, for example, in JP-B-8-301198, Japanese Patent No. 2,543,624, Japanese Patent No. 3,335,683, Japanese Patent No. 3,717,380, Japanese Patent No. 3,897756, Japanese Patent No. 3,962,226, Japanese Patent No. 3,979,866, Japanese Patent No. 3,996,871, Japanese Patent No. 4,000,867, Japanese Patent No. 4,053,837, Japanese Patent No. 4,127,119, Japanese Patent No. 4,134,710, Japanese Patent No. 4,159,154, Japanese Patent No. 4,269,704 and Japanese Patent No. 4,313,538.

In the polymer sheet of the invention, the polyester support preferably has a terminal carboxyl group content AV of 20 eq/t (ton, hereinafter the same) or less, more preferably from 5 to 18 eq/t, and particularly preferably from 9 to 17 eq/t, from the standpoint of enhancing the hydrolysis resistance for suppressing the reduction strength under hygrothermal conditions with the lapse of time.

The carboxyl group content in the polyester may be controlled by the polymerization catalyst species and the solid phase polymerization conditions after the normal polymerization before forming into the film, the film forming condition (such as the film forming temperature and time, the stretching conditions and the thermal relaxation conditions), and the like. In particular, it is preferably controlled by the solid phase polymerization conditions before forming into the polymer support in the film form. The raw material polyester before forming into the polymer support in the film form after the solid phase polymerization preferably has a terminal carboxyl group content of from 1 to 20 eq/t, more preferably from 3 to 18 eq/t, and particularly preferably from 6 to 14 eq/t.

The carboxyl group content (AV) may be measured according to the method described in H.A. Phol, Anal. Chem., 26 (1954), 2145. Specifically, the target polyester is pulverized and dried with a vacuum dryer at 60°C for 30 minutes. The polyester immediately after drying is weighed for 0.1000 g, to which 5 mL of benzyl alcohol is added, and then dissolved therein by heating to 205°C for 2 minutes under stirring. After cooling the solution, 15 mL of chloroform is added to the solution, which is then titrated with an alkali standard solution (a 0.01 N KOH-benzyl alcohol mixed solution) to the neutralization point (pH = 7.3 ± 0.10) by using Phenol Red as an indicator, and the carboxyl group content is calculated from the titer.

In the polymer sheet of the invention, the polymer support preferably has an intrinsic viscosity IV (molecular weight) of 0.65 dL/g or more, more preferably from 0.68 to 0.85 dL/g, and particularly preferably from 0.70 to 0.80 dL/g.

The intrinsic viscosity IV of the polymer support may be controlled by the polymerization catalyst species and the film forming conditions (such as the film forming temperature and time). In particular, it is preferably controlled by the solid phase polymerization conditions before forming into the polymer support in the film form. The raw material polyester before forming into the polymer support in the film form preferably has an intrinsic viscosity IV of from 0.68 to 0.90 dL/g, more preferably from 0.70 to 0.85 dL/g, and particularly preferably from 0.72 to 0.83 dL/g.

The IV value may be measured in such a manner that after pulverizing the target polyester, the polyester is dissolved in a mixed solvent of 1,2,2-tetrachloroethane and phenol (2/3 in mass ratio) to a concentration of 0.01 g/mL, and measured for the IV value with an Ubbelohde viscometer (AVL-6C, produced by Asahi Kasei Technosystem Co., Ltd.) at a temperature of 25°C. The specimen is dissolved at 120°C for from 15 to 30 minutes.

In the polymer sheet of the invention, the polymer support preferably has a peak of Tanδ measured with a dynamic viscoelasticity measuring equipment at 123°C or higher, more preferably from 123 to 130°C, and particularly preferably from 124 to 128°C.

The peak of Tanδ of the polymer support may be controlled by the polymerization catalyst species and the solid phase polymerization conditions after the normal polymerization before forming into the film, the film forming condition (such as film forming temperature and time, the stretching conditions and the thermal relaxation conditions), and the like. In particular, it is preferably controlled by the stretching conditions (including the stretching ratio and the thermal fixation temperature), which may be controlled online.

The peak of Tanδ may be measured after conditioning a specimen for humidity at 25°C and 60%RH for 2 hours or more, by using a commercially available dynamic viscoelasticity measuring equipment (Vibron DVA-225 (produced by ITK Co. , Ltd.) under conditions of a temperature rising rate of 2°C per minute, a measured temperature range of from 30°C to 200°C and a frequency of 1 Hz.

The polymer support is preferably subjected to solid phase polymerization after polymerization. According to the procedure, the preferred carboxyl group content and the preferred intrinsic viscosity may be easily achieved. The solid phase polymerization may be performed by a continuous process (in which the resin filled in a tower is slowly retained for a prescribed period of time while heating, and then discharged therefrom) or a batch process (in which the resin is placed in a vessel and heated for a prescribed period of time) . Specifically, for the solid phase polymerization, such methods may be applied as those described, for example, in Japanese Patent No. 2,621,563, Japanese Patent No. 3,121,876, Japanese Patent No. 3,136,774, Japanese Patent No. 3,603,585, Japanese Patent No. 3,616,522, Japanese Patent No. 3,617,340, Japanese Patent No. 3,680,523, Japanese Patent No. 3,717,392 and Japanese Patent No. 4,167,159.

The temperature for the solid phase polymerization is preferably from 170 to 240°C, more preferably from 180 to 230°C, and further preferably from 190 to 220°C. The solid phase polymerization time is preferably from 5 to 100 hours, more preferably from 10 to 75 hours, and further preferably from 15 to 50 hours. The solid phase polymerization is preferably performed in vacuum or in a nitrogen atmosphere.

The polymer support in the invention is preferably, for example, a biaxially stretched film that is obtained in such a manner that the polyester is melt-extruded into a film form and solidified by cooling with a casting drum to form an unstretched film, and the unstretched film is stretched in the machine direction at from Tg to (Tg+60°C) once or twice or more in a ratio of from 3 to 6 times in total, and then stretched in the transverse direction at from Tg to (Tg+60°C) in a ratio of from 3 to 5 times.

The polymer support in the invention is preferably formed into the film by subjecting to a heat treatment after stretching, from the standpoint of the improvement of the hydrolysis resistance and the control of the thermal shrinkage. The heat treatment is preferably at from 150 to 230°C, more preferably from 180 to 225°C, and further preferably from 190 to 215°C. The heat treatment time is preferably from 5 to 60 seconds, more preferably from 10 to 40 seconds, and further preferably from 10 to 30 seconds.

The polymer support is preferably formed into the film by subjecting to thermal relaxation after stretching, from the standpoint of the control of the thermal shrinkage. The thermal relaxation is preferably from 1 to 10%, more preferably from 3 to 7%, and particularly preferably from 4 to 6%, in the machine direction, and is preferably from 3 to 20%, more preferably from 6 to 16%, and further preferably from 8 to 13%, in the transverse direction.

The polymer support is preferably in such embodiment that it is subjected to a surface treatment by a corona treatment, a flame treatment, a low pressure plasma treatment, an atmospheric pressure plasma treatment or an ultraviolet ray treatment. By performing the surface treatment to the coating surface before coating the layers, the adhesiveness on exposing hygrothermal conditions may be further enhanced. Among these, a corona treatment is particularly preferably performed for providing further enhancement of the adhesiveness.

The surface treatment performed increases a carboxyl group and a hydroxyl group on the surface of the polymer support (such as a polyester substrate), thereby enhancing the adhesiveness between the polymer support and the coated layer, and the combination use of a crosslinking agent (particularly an oxazoline or carbodiimide crosslinking agent having high reactivity to a carboxyl group) may provide further larger adhesiveness. This may be conspicuous in the case where a corona treatment is performed. Accordingly, the surface of the polymer support is particularly preferably subjected to a corona treatment.

Weather Resistant Layer as Layer containing Binder, Colorant and Scattering Particles

The case where the polymer sheet of the invention has a weather resistant layer as a layer containing the

binder, the colorant and the scattering particles will be described.

In a solar cell having a laminated structure containing a cell-side substrate (i.e., a transparent substrate (such as a glass substrate) on the side, on which solar light is incident), a device structure containing a solar cell device, and a back sheet for a solar cell, the weather resistant layer is a back protective layer that is disposed on the opposite surface of the polymer support as a support to the surface facing the cell-side substrate. The weather resistant layer as the layer containing the binder, the colorant and the scattering particles is preferably a back layer positioned on the back surface side of the solar cell device that is disposed as the outermost layer farthest from the polymer support.

The weather resistant layer may be formed only of a single layer or may be formed of plural layers laminated. In the case where the weather resistant layer is provided as a single layer, such an embodiment is preferred that a layer containing the binder, the colorant and the scattering particles is provided on the polymer support. In the case where plural layers are laminated as the weather resistant layer, preferred examples of the case include an embodiment where two layers each containing the binder, the colorant and the scattering particles are provided on the polymer support, and an embodiment where a layer containing the binder, the colorant and the scattering particles is provided on the polymer support, and the weather resistant layer that contains an arbitrary fluorine polymer is further laminated thereon.

Binder

The binder may contain an organic polymer, an inorganic polymer or an organic-inorganic hybrid polymer, and the polymer contained improves the adhesion property to the polymer support and the interlayer adhesion in the case where the back layer is formed of two or more layers, and also provides resistance to deterioration under hygrothermal conditions.

The inorganic polymer is not particularly limited, and any known inorganic polymer may be used.

The organic polymer and the organic-inorganic hybrid polymer are not particularly limited, and the polymer preferably contains at least one of a fluorine polymer and a silicone polymer, more preferably contains at least one of a fluorine organic polymer and a silicone-acrylic organic-inorganic hybrid resin, and particularly preferably contains a silicone-acrylic organic-inorganic hybrid resin.

Silicone Polymer

The silicone polymer herein means a polymer containing at least one kind of a polymer having a (poly) siloxane structure in the molecular structure thereof. The silicone polymer contained may enhance the adhesion property to the adjacent layer, such as the polymer support and the fluorine polymer layer as the weather resistant layer, and the durability under hygrothermal conditions.

The silicone polymer is not particularly limited as far as it has a (poly) siloxane structure in the molecular structure thereof, and preferred examples thereof include a homopolymer of a compound having a (poly) siloxane structure, and a copolymer of a compound having a (poly)siloxane structure and another compound, i.e., a copolymer having a (poly) siloxane structural unit and another structural unit. The another compound may be a non-siloxane monomer or polymer, and the another structural unit may be a non-siloxane structural unit.

The silicone polymer preferably has, as the (poly)siloxane structure, a (poly)siloxane structure represented by the following general formula (1):

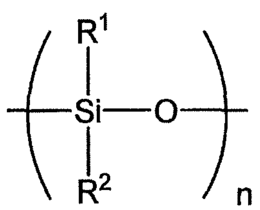

General Formula (1)

In the general formula (1), $R^1$ and $R^2$ each independently represent a hydrogen atom, a halogen atom or a monovalent organic group. $R^1$ and $R^2$ may be the same as or different from each other. Plural groups represented by $R^1$ or $R^2$ may be the same as or different from each other. n represents an integer of 1 or more.

In the portion represented by - $(Si(R^1)(R^2)-O)_n$-, which is a (poly)siloxane segment, in the silicone polymer (i.e., the (poly)siloxane structural unit represented by the general formula (1)), $R^1$ and $R^2$ may be the same as or different from each other and each represent a hydrogen atom, a halogen atom or a monovalent organic group.

The portion represented by -$(Si(R^1)(R^2)-O)_n$- is a (poly)siloxane segment derived from various kinds of (poly) siloxane having a linear, branched or cyclic structure.

Examples of the halogen atom represented by $R^1$ and $R^2$ include a fluorine atom, a chlorine atom and an iodine

atom.

The monovalent organic group represented by $R^1$ and $R^2$ may be a group capable of forming a covalent bond to the Si atom, and may be unsubstituted or may have a substituent. Examples of the monovalent organic group include an alkyl group (such as a methyl group and an ethyl group), an aryl group (such as a phenyl group), an aralkyl group (such as a benzyl group and a phenylethyl group), an alkoxy group (such as a methoxy group, an ethoxy group and a propoxy group), an aryloxy group (such as a phenoxy group), a mercapto group, an amino group (such as an amino group and a diethylamino group), and an amide group.

Among these, $R^1$ and $R^2$ each preferably independently represent a hydrogen atom, a chlorine atom, a bromine atom, an unsubstituted or substituted alkyl group having from 1 to 4 carbon atoms (particularly a methyl group and an ethyl group), an unsubstituted or substituted phenyl group, a substituted alkoxy group, a mercapto group, an unsubstituted or substituted amino group, or an amide group from the standpoint of the adhesion property to the polymer substrate and the weather resistant layer using a fluorine polymer and the durability under hygrothermal conditions, and more preferably an unsubstituted or substituted alkoxy group (preferably an alkoxy group having from 1 to 4 carbon atoms) from the standpoint of the durability under hygrothermal conditions.

n is preferably from 1 to 5,000, and more preferably from 1 to 1,000.

The proportion of the portion represented by $-(Si(R^1)(R^2)-O)_n-$ (i.e., the (poly)siloxane structural unit represented by the general formula (1)) in the silicone polymer is preferably from 15 to 85% by mass based on the total mass of the silicone polymer, and more preferably from 20 to 80% by mass from the standpoint of enhancement of the adhesion property to the polymer substrate and the weather resistant layer using a fluorine polymer and the durability under hygrothermal conditions. When the proportion of the (poly)siloxane structural unit is 15% by mass or more, the strength of the surface of the weather resistant layer may be enhanced to prevent damages from occurring due to scratch or abrasion, and collision of flying pebbles, and the adhesion property to the adjacent material, such as the polymer support constituting the support, may be enhanced. The prevention of damages may enhances the weather resistance, thereby enhancing the stripping resistance, which is liable to be deteriorated on application of heat and water, the dimensional stability, and the adhesion durability on exposure to hygrothermal conditions. When the proportion of the (poly)siloxane structural unit is 85% by mass or less, the liquid may be maintained stable.

The silicone-acrylic hybrid resin in the invention maybe a copolymer having a (poly) siloxane structural unit and at least an acrylic structural unit. The copolymer preferably contains from 15 to 85% by mass in terms of mass proportion of the (poly)siloxane structural unit represented by the general formula (1) and from 85 to 15% by mass in terms of mass proportion of an acrylic structural unit. The use of the copolymer contained may enhance the film strength of the weather resistant layer, may prevent damages from occurring due to scratch and abrasion, and may drastically enhance the adhesion property to the polymer support constituting the support and the weather resistant layer using a fluorine polymer, i.e., the stripping resistance, which is liable to be deteriorated on application of heat and water, the dimensional stability, and the durability on exposure to hygrothermal conditions, as compared to the ordinary ones.

The copolymer is preferably a block copolymer formed by copolymerization of a siloxane compound (including a polysiloxane) and a compound selected from a non-siloxane monomer and a non-siloxane polymer and having a (poly) siloxane structural unit represented by the general formula (1) and a non-siloxane structural unit. In this case, the siloxane compound and the non-siloxane monomer or the non-siloxane polymer to be copolymerized each may be used solely or may contain two or more kinds thereof.

The non-siloxane structural unit (derived from the non-siloxane monomer or the non-siloxane polymer) to be copolymerized with the (poly)siloxane structural unit is not particularly limited as far as it contains an acrylic structural unit, and may be any polymer segment derived from an arbitrary polymer. Examples of a polymer (i.e., a precursor polymer) that is a precursor of the polymer segment include various polymers, such as a vinyl polymer, a polyester polymer and a polyurethane polymer.

Among these, a vinyl polymer and a polyurethane polymer are preferred, and a vinyl polymer is particularly preferred, from the standpoint of the convenience in preparation and the excellent hydrolysis resistance.

Representative examples of the vinyl polymer include various polymers, such as an acrylic polymer, a vinyl carboxylate ester polymer, an aromatic vinyl polymer and a fluoroolefin polymer. Among these, an acrylic polymer is preferred from the standpoint of the degree of freedom in design. In the polymer sheet of the invention, the silicone-acrylic hybrid resin in the weather resistant layer is preferably a hybrid polymer of a silicone resin and an acrylic resin.

The polymer constituting the non-siloxane structural unit may be used solely or a combination of two or more kinds thereof.

The precursor polymer constituting the non-siloxane structural unit preferably contains at least one of an acid group and a neutralized acid group and/or a hydrolyzable silyl group. The vinyl polymer may be prepared by various methods, such as (a) a method, in which a vinyl monomer containing an acid group and a vinyl monomer containing a hydrolyzable silyl and/or silanol group are copolymerized with a monomer capable of being copolymerized therewith, (2) a method, in which a polycarboxylic anhydride is reacted with a vinyl polymer prepared in advance containing a hydroxyl group and a hydrolyzable silyl and/or silanol group, and (3) a method, in which a compound having active

hydrogen (such as water, an alcohol and an amine) is reacted with a vinyl polymer prepared in advance containing an acid anhydride group and a hydrolyzable silyl and/or silanol group.

The precursor polymer may be produced and available, for example, according to the method described in paragraphs 0021 to 0078 of JP-A-2009-52011.

The weather resistant layer in the invention may contain, as the binder, the silicone-acrylic hybrid resin solely and may contain another polymer in combination. In the case where another polymer is used, the content ratio of the silicone-acrylic hybrid resin containing the (poly)siloxane structure in the invention is preferably 30% by mass or more, and more preferably 60% by mass or more, based on the total amount of the binder. When the content ratio of the silicone-acrylic hybrid resin is 30% by mass or more, the adhesion property to the polymer support and the weather resistant layer containing a fluorine polymer, and the durability under hygrothermal conditions may be enhanced.

The molecular weight of the silicone-acrylic hybrid resin is preferably from 5, 000 to 100,000, and more preferably from 10,000 to 50,000.

For preparing the silicone-acrylic hybrid resin, such methods may be used as (i) a method, in which the precursor polymer and a polysiloxane having the structural unit represented by the general formula (1) are reacted, and (ii) a method, in which a silane compound having the structural unit represented by the general formula (1), in which $R^1$ and/or $R^2$ is a hydrolyzable group, is hydrolytically condensed in the presence of the precursor polymer.

Examples of the silane compound used in the method (ii) include various silane compounds, and an alkoxysilane compound is particularly preferred.

In the case where the silicone-acrylic hybrid resin is prepared by the method (i), for example, the resin may be prepared in such a manner that water and a catalyst are added depending on necessity to a mixture of the precursor polymer and the polysiloxane, and the mixture is reacted at a temperature of approximately from 20 to 150°C for a period of time of approximately from 30 minutes to 30 hours (preferably from 50 to 130°C and from 1 to 20 hours). The catalyst added may be various silanol condensation catalysts, such as an acidic compound, a basic compound and a metal-containing compound.

In the case where the silicone-acrylic hybrid resin is prepared by the method (ii), for example, the resin may be prepared in such a manner that water and a silanol condensation catalyst were added to a mixture of the precursor polymer and the alkoxysilane compound, and hydrolytic condensation is performed at a temperature of approximately from 20 to 150°C for a period of time of approximately from 30 minutes to 30 hours (preferably from 50 to 130°C and from 1 to 20 hours).

The silicone-acrylic hybrid resin having a (poly)siloxane structure may be a commercially available product, for example, Ceranate series, produced by DIC Corporation (such as Ceranate WSA 1070 and WSA 1060), H7600 series, produced by Asahi Kasei Corporation (such as H7650, H7630 and H7620), and an inorganic-acrylic hybrid emulsion, produced by JSR Corporation, may be used.

The content ratio of the silicone-acrylic hybrid resin having a (poly)siloxane structure in one layer of the weather resistant layer is preferably in a range of more than 0.2 $g/m^2$ and 15 $g/m^2$ or less. When the content ratio of the polymer is 0.2 $g/m^2$ or more, the proportion of the silicone-acrylic hybrid resin may be sufficient to improve the resistance to damages. When the content ratio of the silicone-acrylic hybrid resin is 15 $g/m^2$ or less, the proportion of the silicone-acrylic hybrid resin may not be too large, and thereby the weather resistant layer may be sufficiently hardened.

In the aforementioned ranges, a range of from 0.5 to 10.0 $g/m^2$ is preferred, and a range of from 1.0 to 5.0 $g/m^2$ is more preferred.

The thickness of the weather resistant layer containing the silicone-acrylic hybrid resin is preferably in a range of from 0.8 to 12 $\mu m$. When the thickness of the weather resistant layer containing the silicone-acrylic hybrid resin is 0.8 $\mu m$ or more, the layer may have sufficient durability (weather resistance) as the polymer sheet for a back sheet for a solar cell, particularly the outermost layer thereof, and when the thickness is 12 $\mu m$ or less, the surface shape thereof may be prevented from being deteriorated, and the adhesion force to the another layer may be sufficient. When the thickness of the weather resistant layer containing the silicone-acrylic hybrid resin is in a range of from 0.8 to 12 $\mu m$, both the durability and the surface shape may be achieved, and a range of approximately from 1.0 to 10 $\mu m$ is particularly preferred.

Fluorine Polymer

The weather resistant layer may also be constituted by a fluorine polymer (i.e., a fluorine-containing polymer) as a major binder. The major binder herein means a binder that has the largest content in the layer.

The fluorine polymer used in the weather resistant layer is not particularly limited as far as the polymer has a repeating unit represented by $-(CFX^1-CX^2X^3)-$ (wherein $X^1$, $X^2$ and $X^3$ each represent a hydrogen atom, a fluorine atom, a chlorine atom or a perfluoroalkyl group having from 1 to 3 carbon atoms). Specific examples of the polymer include polytetrafluoroethylene (which may be hereinafter referred to as PTFE), polyvinyl fluoride (which may be hereinafter referred to as PVF), polyvinylidene fluoride (which may be hereinafter referred to as PVDF), polychlorotrifluoroethylene

(which may be hereinafter referred to as PCTFE) and polytetrafluoropropylene (which may be hereinafter referred to as HFP).

The polymer may be a homopolymer obtained by polymerizing a single monomer or may be a copolymer obtained by polymerizing two or more kinds of monomers. Examples thereof include a copolymer obtained by copolymerizing tetrafluoroethylene and tetrafluoropropylene (which may be abbreviated as P(TFE/HFP)) and a copolymer obtained by copolymerizing tetrafluoroethylene and vinylidene fluoride (which may be abbreviated as

P(TFE/VDF)).

The polymer used in the weather resistant layer containing a fluorine polymer may be a polymer obtained by copolymerizing a fluorine polymer represented by - ($CFX^1$-$CX^2X^3$) - and another monomer. Examples thereof include a copolymer of tetrafluoroethylene and ethylene (which may be abbreviated as P(TFE/E)), a copolymer of tetrafluoroethylene and propylene (which may be abbreviated as P(TFE/P)), a copolymer of tetrafluoroethylene and vinyl ether (which may be abbreviated as P(TFE/VE)), a copolymer of tetrafluoroethylene and perfluorovinyl ether (which may be abbreviated as P(TFE/FVE)), a copolymer of chlorotrifluoroethylene and vinyl ether (which may be abbreviated as P(CTFE/VE)) and a copolymer of chlorotrifluoroethylene and perfluorovinyl ether (which may be abbreviated as P(CTFE/FVE)).

The fluorine polymer may be used after dissolving the polymer in an organic solvent or after dispersing fine particles of the polymer in water. The latter is preferred due to the less environmental load. For the water dispersion of the fluorine polymer, reference may be made, for example, to JP-A-2003-231722, JP-A-2002-20409 and JP-A-9-194538.

The binder in the weather resistant layer containing the fluorine resin may be the fluorine polymer solely or a combination of two or more kinds thereof. A resin other than the fluorine polymer, such as an acrylic resin, a polyester resin, a polyurethane resin, a polyolefin resin and a silicone resin, may be used in combination in an amount that does not exceeds 50% by mass. When the resin other than the fluorine polymer is used in an amount exceeding 50% by mass in the back sheet, the weather resistance may be deteriorated in some cases.

The thickness of the weather resistant layer containing the fluorine polymer is preferably in a range of from 0.8 to 12 μm. When the thickness of the weather resistant layer containing the fluorine polymer is 0.8 μm or more, the layer may have sufficient durability (weather resistance) as the polymer sheet for a back sheet for a solar cell, particularly the outermost layer thereof, and when the thickness is 12 μm or less, the surface shape thereof may be prevented from being deteriorated, and the adhesion force to the another layer may be sufficient. When the thickness of the weather resistant layer containing the fluorine polymer is in a range of from 0.8 to 12 μm, both the durability and the surface shape may be achieved, and a range of approximately from 1.0 to 10 μm is particularly preferred.

Colorant

The colorant is not particularly limited, and a known dye, a known pigment and the like may be used. The colorant herein does not include scattering particles.

In the invention, the colorant is preferably a black colorant, a green colorant, a blue colorant or a red colorant.

The colorant pigment used in the weather resistant layer is not particularly limited but preferably contains at least one kind selected from carbon black, titanium black, a black composite metal oxide, a cyanine colorant and a quinacridone colorant, and the colorant may be selected depending on the target optical density.

The black composite metal oxide is preferably a composite metal oxide containing at least one kind of iron, manganese, cobalt, chromium, copper and nickel, more preferably a composite oxide containing at least two kinds of cobalt, chromium, iron, manganese, copper and nickel, and is particularly preferably at least one pigment selected from PBk 26, PBk 27, PBk 28 and PBr 34 of color index.

The pigment of PBk 26 is a composite oxide of iron, manganese and copper, the pigment of PBk 27 is a composite oxide of iron, cobalt and chromium, the composite oxide of PBk 28 is a composite oxide of copper, chromium and manganese, and a composite oxide of PBr 34 is a composite oxide of nickel and iron.

Examples of the cyanine colorant and the quinacridone colorant include Cyanine Green, Cyanine Blue, Quinacridone Red, Phthalocyanine Blue and Phthalocyanine Green.

In the polymer sheet of the invention, the colorant is preferably carbon black from the standpoint that the optical density may be easily controlled to the preferred range, and the standpoint that the optical density may be controlled with a small amount thereof.

The carbon black is preferably carbon black fine particles having a particle diameter of from 0. 1 to 0. 8 μm. The carbon black fine particles are preferably used after dispersing in water along with a dispersant.

The carbon black used may be a commercially available product, and for example, MF-5630 Black (produced by Dainichiseika Color & Chemicals Mfg. Co., Ltd.) and those described in paragraph [0035] of JP-A-2009-132887) may be used.

Scattering Particles

The scattering particles are not particularly limited, and known scattering particles may be used. The scattering particles referred herein means particles that have substantially no light absorption by themselves and do not include the colorant.

In the invention, the scattering particles used are preferably a white pigment.

The white pigment as the scattering particles is preferably an inorganic pigment, such as titanium dioxide, barium sulfate, silicon oxide, aluminum oxide, magnesium oxide, calcium carbonate, kaolin, talc and colloidal silica, and an organic pigment, such as hollow particles.

Among these, in the polymer sheet of the invention, the scattering particles are preferably titanium dioxide.

The crystalline system of titanium dioxide includes a rutile type, an anatase type and a brookite type, and the titanium dioxide used in the invention is preferably a rutile type among these. The titanium dioxide used in the invention may be surface-treated with aluminum oxide ($Al_2O_3$), silicon dioxide ($SiO_2$), an alkanolamine compound, a silicone compound and the like, depending on necessity.

In particular, by using titanium dioxide having a bulk density of 0. 50 g/cm$^3$ or more, the titanium dioxide may be filled densely to toughen the weather resistant layer. When titanium dioxide having a bulk density exceeding 0.85 g/cm$^3$ is used, the titanium dioxide may be deteriorated in dispersibility to deteriorate the surface shape of the coated layer. When the bulk density is from 0.50 to 0.85 g/cm$^3$, the titanium dioxide may be filled densely, and the coated film may be toughened, thereby maintaining the adhesiveness when the mass proportion of the titanium dioxide is large. The bulk density of the titanium dioxide used in the weather resistant layer is particularly preferably from 0.60 to 0.80 g/cm$^3$.

The bulk density herein of the white pigment is a value measured in the following manner.

(1) A pigment is sieved through a 1.0-mm mesh.
(2) Approximately 100 g (m) of the pigment is weighed and placed gently in a 250-mL measuring cylinder. The upper surface of the pigment is flattened depending on necessity without pressing, and the volume (V) thereof is measured.
(3) The bulk density is obtained according to the following expression.

bulk density = m/V (unit: g/cm$^3$)

By adding the white pigment to the weather resistant layer in addition to the silicone polymer, the polymer sheet may have a high reflectivity, and may be reduced in yellowing under a long-term high temperature and high humidity test (at 85°C and 85%HR for 2,000 to 3,000 hours) and an UV irradiation test (according to the UV test of IEC 61215 with a total irradiation amount of 45 Kwh/m$^2$). Furthermore, the addition of the white pigment to the weather resistant layer may improve the adhesiveness to the other layers.

In the polymer sheet of the invention, the content of the white pigment contained in the weather resistant layer is preferably from 1.0 to 15 g/m$^2$ per one layer of the weather resistant layer. When the content of the white pigment is 1.0 g/m$^2$ or more, the reflectance and the UV resistance (light resistance) may be effectively imparted. When the content of the white pigment in the weather resistant layer is 15 g/m$^2$ or less, the surface shape of the colored layer may be maintained favorably, and a high film strength may be provided. In particular, the content of the white pigment contained in the weather resistant layer is more preferably in a range of from 2.5 to 10 g/m$^2$ per one layer of the weather resistant layer, and particularly preferably in a range of from 4.5 to 8.5 g/m$^2$.

The average particle diameter of the white pigment is preferably from 0.03 to 0.8 $\mu$m, and more preferably approximately from 0.15 to 0.5 $\mu$m, in terms of volume average particle diameter. When the average particle diameter is in the range, a high light reflection efficiency may be obtained. The average particle diameter is a value measured with a laser analyzing/scattering particle sizer, LA950 (produced by Horiba, Ltd.).

The content of the binder component (including the silicone polymer) in the weather resistant layer is preferably in a range of from 15 to 200% by mass, and more preferably in a range of from 17 to 100% by mass, based on the white pigment. When the content of the binder is 15% by mass or more, the colored layer may have a sufficient strength, and when the content thereof is 200% by mass or less, the reflectance and the decorativeness may be maintained favorably.

Other Components in Weather Resistant Layer

In the case where the polymer sheet of the invention has the weather resistant layer as the layer containing the binder, the colorant and the scattering particles, the layer may further contain other components, such as various additives, depending on necessity.

Examples of the components that may be contained in the weather resistant layer include a crosslinking agent, a surfactant and a filler.

A crosslinking agent may be added to the binder (binder resin) that mainly constitutes the weather resistant layer to form the weather resistant layer, thereby providing a crosslinked structure derived from the crosslinking agent.

Examples of the crosslinking agent include crosslinking agents of an epoxy series, an isocyanate series, a melamine series, a carbodiimide series and an oxazoline series. Among these, at least one kind of a crosslinking agent selected from a carbodiimide crosslinking agent, an oxazoline crosslinking agent and an isocyanate crosslinking agent is preferred.

Specific examples of the oxazoline crosslinking agent include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-ethyl-2-oxazoline, 2,2'-bis(2-oxazoline), 2,2'-methylene-bis(2-oxazoline), 2,2'-ethylene-bis(2-oxazoline), 2,2'-trimethylene-bis(2-oxazoline), 2,2'-tetramethylene-bis(2-oxazoline), 2,2'-hexamethylene-bis(2-oxazoline), 2,2'-octamethylene-bis(2-oxazoline), 2,2'-ethylene-bis(4,4'-dimethyl-2-oxazoline), 2,2'-p-phenylene-bis(2-oxazoline), 2,2'-m-phenylene-bis(2-oxazoline), 2,2'-m-phenylene-bis(4,4'-dimethyl-2-oxazoline), bis(2-oxazolinylcyclohexane) sulfide and bis(2-oxazolinylnorbornane) sulfide. (Co)polymers of these compounds may also be preferably used.

A compound having an oxazoline group, such as Epocros K2010E, K2020E, K2030E, WS-500 and WS-700 (all produced by Nippon Shokubai Co., Ltd.), may also be used as the compound having an oxazoline group.

Specific examples of the carbodiimide crosslinking agent include dicyclohexylmethane carbodiimide, tetramethylxylylene carbodiimide and dicyclohexylmethane carbodiimide. The carbodiimide compounds described in JP-A-2009-235278 are also preferred. Specifically, as the carbodiimide crosslinking agent, the commercially available products, such as Carbodilite SV-02, Carbodilite V-02, Carbodilite V-02-L2, Carbodilite V-04, Carbodilite E-01 and Carbodilite E-02 (all produced by Nisshinbo Chemical Inc.), may also be used.

The isocyanate crosslinking agent is preferably a blocked isocyanate, an isocyanate blocked with dimethylpyrazole is more preferred, and an isocyanate blocked with 3, 5-dimethylpyrazole is particularly preferred. Examples of the isocyanate crosslinking agent that is preferably used in the invention include Trixene series DP9C/214, produced by Baxenden Chemicals Ltd., and BI7986, produced by Baxenden Chemicals Ltd.

The amount of the crosslinking agent added is preferably from 0.5 to 30% by mass, and more preferably from 3% by mass or more and less than 15% by mass, based on the binder constituting the weather resistant layer. When the amount of the crosslinking agent added is 0.5% by mass or more, a sufficient crosslinking effect may be obtained while maintaining the strength and the adhesion property of the weather resistant layer. When the amount is 30% by mass or less, the coating liquid may have a prolonged pot life, and when the amount is less than 15% by mass, the coated surface shape may be improved.

The surfactant used may be a known surfactant, such as an anionic one and a nonionic one. In the case where the surfactant is added, the amount thereof added is preferably from 0.1 to 10 $mg/m^2$, and more preferably from 0.5 to 3 $mg/m^2$. When the amount of the surfactant added is 0.1 $mg/m^2$ or more, the layer may be favorably formed while preventing the coating liquid being repelled, and when the amount is 10 $mg/m^2$ or less, the adhesion to the polymer support and the like may be improved.

The weather resistant layer may further contain a filler. The filler used may be a known filler, such as colloidal silica.

The weather resistant layer may be formed by coating and then drying a coating liquid containing the binder and the like on the polymer support. In the polymer sheet of the invention, the weather resistant layer is preferably a coated layer that is formed by coating an aqueous composition for a weather resistant layer containing at least one of the fluorine polymer and the silicone-acrylic hybrid resin. The production method of the polymer sheet of the invention is preferably such an embodiment that an aqueous dispersion liquid containing the silicone-acrylic hybrid resin dispersed in water is prepared, and the aqueous dispersion liquid is coated as an aqueous coating liquid on the desired polymer support in the step of forming a weather resistant layer. The coating method and the solvent in the coating liquid are not particularly limited.

The coating method used may be, for example, a gravure coater or a bar coater.

The solvent used in the coating liquid may be water or an organic solvent, such as toluene and methyl ethyl ketone. An aqueous coating liquid containing water as a coating solvent is preferably prepared from the standpoint of the environmental load.

The coating solvent may be used solely or as a mixture obtained by mixing two or more kinds thereof. An aqueous coating liquid obtained by dispersing the binder in water is preferably formed and coated. In this case, the proportion of water in the solvent is preferably 60% by mass or more, and more preferably 80% by mass or more.

After coating, a drying step of drying the coated film under desired conditions may be provided. The drying temperature on drying may be appropriately selected depending on the composition of the coating liquid and the coated amount thereof.

In the case where the polymer support is a biaxially stretched film, such a method may be used that the coating liquid for forming the weather resistant layer is coated on the polymer support having been biaxially stretched, and then the coated film is dried, and such a method may also be used that the coating liquid is coated and dried on the polymer support having been uniaxially stretched, and then the polymer support is stretched in a direction that is different from the initial stretching. Furthermore, such a method may also be used that the coating liquid is coated and dried on the

polymer support before stretching, and then the polymer support is stretched biaxially.

Thickness

The thickness of one layer of the weather resistant layer is generally preferably from 0.3 to 22 μm, more preferably from 0.5 to 15 μm, further preferably from 0.8 to 12 μm, particularly preferably from 1.0 to 8 μm, and most preferably from 2 to 6 μm. When the thickness of the weather resistant layer is 0.3μ m or more, and further 0.8 μm or more, water may be prevented from penetrating from the surface of the weather resistant layer into the interior thereof on exposing to hygrothermal conditions, and water may be difficult to reach the interface between the weather resistant layer and the polymer support, thereby enhancing considerably the adhesion property. When the thickness of the weather resistant layer is 22 μm or less, and further 12 μm or less, the weather resistant layer itself may be prevented from being reduced in strength, and the weather resistant layer may be prevented from being broken on exposing to hygrothermal conditions, thereby enhancing the adhesion property.

White Layer

The polymer sheet of the invention preferably contains a white layer containing a white pigment. The white layer may further contain various additives depending on necessity. The white layer preferably has a peeling force to the sealant of 5 N/cm or more.

The functions of the white layer include a function of maintaining the adhesion to the sealant under various environments, and a function of reflecting a component of light in the solar light that reaches the back sheet without contributing to the electric power generation through the solar cell, thereby enhancing the electric power generation efficiency of the solar cell module.

Polymer

The white layer preferably contains at least one kind of a polymer selected from a polyolefin resin, an acrylic resin and a polyvinyl alcohol resin as a binder from the standpoint that the adhesiveness to EVA and the like used as the sealant in the solar cell module may be 5 N/cm or more. Among these, an acrylic resin and a polyolefin are preferred from the standpoint of the durability.

The white layer more preferably contains a binder that is derived from an aqueous latex as the binder.

Examples of the preferred binder include a polyolefin, specific examples of which include Arrowbase SE-1010 and SE-1013N (both produced by Unitika Ltd.) and Chemipearl S-120 and S-75N (both produced by Mitsui Chemicals, Inc.), and an acrylic resin, specific examples of which include Julimer ET-410 and SEK-301 (all produced by Nippon Junyaku Co., Ltd.).

The content of the binder in the white layer is preferably in a range of from 0.05 to 5 $g/m^2$, and in particular, a range of from 0.08 to 3 $g/m^2$ is more preferred. When the content of the binder is 0.05 $g/m^2$ or more, the desired adhesion force may be obtained, and when the content is 5 $g/m^2$ or less, a good surface shape may be obtained.

The adhesiveness of the white layer to EVA used as a sealant in the solar cell module is preferably 5 N/cm or more, more preferably more than 30 N/cm, and further preferably from 50 to 150 N/cm.

White Pigment

The white layer in the invention may contain at least one kind of a white pigment.

The white pigment is preferably an inorganic pigment, such as titanium dioxide, barium sulfate, silicon oxide, aluminum oxide, magnesium oxide, calcium carbonate, kaolin, talc and colloidal silica, and an organic pigment, such as hollow particles, and among these, the white pigment is more preferably titanium dioxide.

In the polymer sheet, the volume fraction of the white pigment with respect to the white layer is preferably from 15 to 50%, more preferably from 18 to 30%, and particularly preferably from 20 to 25%. When the volume fraction of the white pigment with respect to the white layer is 15% or more, a good coated surface shape may be obtained, and a sufficient reflectance may be obtained. When the volume fraction of the white pigment with respect to the white layer is 50% or less, the white layer may be prevented from suffering cohesive breakage due to the insufficient strength thereof, and the adhesion between the white layer and the sealant and the adhesion between the white layer and the undercoating layer before and after undergoing hygrothermal conditions may be favorably improved.

The volume fraction of the pigment in the polymer layer may be calculated according to the following expression.
volume fraction of pigment (%) = volume of pigment / (volume of binder + volume of pigment)

The volumes of the pigment and the binder may be measured, or the volumes of the pigment and the binder may be obtained from calculation of (mass of pigment)/(specific gravity of pigment) and (mass of binder)/(specific gravity

of binder), respectively.

The content of the pigment in the white layer is preferably in a range of from 3 to 18 g/$m^2$, more preferably in a range of from 3.5 to 15 g/$m^2$, and particularly preferably in a range of from 4.5 to 10 g/$m^2$. When the content of the pigment is 3.0 g/$m^2$ or more, the necessary coloration may be obtained, and the reflectance and the decorative property may be effectively achieved. When the content of the pigment in the white layer is 18 g/$m^2$ or less, the surface shape of the white layer may be maintained favorably, and an excellent film strength may be obtained.

The average particle diameter of the pigment is preferably from 0.03 to 0.8 μm, and more preferably approximately from 0.15 to 0.5 μm, in terms of volume average particle diameter. When the average particle diameter is in the range, a high light reflection efficiency may be obtained. The average particle diameter is a value measured with a laser analyzing/scattering particle sizer, LA950 (produced by Horiba, Ltd.).

In the case where the white layer is provided, the surface on the side having the white layer provided (i.e., the outermost surface) preferably has a light reflectance at 550 nm of 75% or more, and more preferably 80% or more. The light reflectance herein for the case where the polymer sheet of the invention is used as a back protective sheet for a solar cell is the ratio of the amount of light that is incident on the sealant side of the solar cell module, reflected by the white layer and then emitted from the sealant side of the solar cell module, with respect to the amount of light that is incident on the solar cell. Light having a wavelength of 550 nm is used herein as light having the representative wavelength.

When the light reflectance is 75% or more, light incident on the interior of the cell through the cell may be returned efficiently to the cell to enhance the electric power generation efficiency. The light reflectance may be controlled to 75% or more, for example, by controlling the content of the white pigment to a range of from 2.5 to 30 g/$m^2$.

The white layer may contain a crosslinking agent, a surfactant, a filler and the like.

Crosslinking Agent

In the invention, the white layer preferably has a partial structure derived from a crosslinking agent that crosslinks the polymer.

Examples of the crosslinking agent include crosslinking agents of an epoxy series, an isocyanate series, a melamine series, a carbodiimide series and an oxazoline series. By crosslinking with the crosslinking agent, the adhesion after undergoing hygrothermal conditions, specifically the adhesion to the adjacent materials, such as the sealant, after exposing to hygrothermal conditions, may be enhanced.

Examples of the crosslinking agent include crosslinking agents of an epoxy series, an isocyanate series, a melamine series, a carbodiimide series and an oxazoline series. Among these crosslinking agent, crosslinking agents of a carbodiimide series, an oxazoline series and the like are preferred. The descriptions and the preferred ranges of the crosslinking agents of a carbodiimide series and an oxazoline series may be the same as the descriptions and the preferred ranges of the crosslinking agents that may be used in the weather resistant layer.

The amount of the crosslinking agent added is preferably from 5 to 50% by mass, and more preferably from 10 to 40% by mass, based on the binder in the layer. When the amount of the crosslinking agent added is 5% by mass of more, the sufficient crosslinking effect may be obtained while maintaining the strength and the adhesion property of the colored layer, and when the amount is 50% by mass or less, the coating liquid may have a prolonged pot life.

Surfactant

The surfactant used may be a known surfactant, such as an anionic one and a nonionic one. In the case where the surfactant is added, the amount thereof added is preferably from 0.1 to 15 mg/$m^2$, and more preferably from 0.5 to 5 mg/$m^2$. When the amount of the surfactant added is 0.1 mg/$m^2$ or more, the layer may be favorably formed while preventing the coating liquid being repelled, and when the amount is 15 mg/$m^2$ or less, the adhesion may be favorably performed.

Formation Method of White Layer

The white layer may be formed by such methods as a method of adhering a polymer sheet containing a pigment, a method of co-extruding a colored layer in the formation of substrate, a coating method, and the like. Specifically, the white layer may be formed by adhering, co-extruding, coating, or the like directly on the surface of the polymer support or with an undercoating layer described later intervening therebetween.

Among the methods, the coating method is preferred since the method is convenient and may form a uniform thin film.

Examples of the coating method for coating include known coating methods, such as a gravure coater, a bar coater and the like.

The coating liquid may be an aqueous one using water as a coating solvent, or may be a solvent-based one

using an organic solvent, such as toluene and methyl ethyl ketone. Among these, water is preferably used as the solvent from the standpoint of the environmental load. The coating solvent may be used solely or as a mixture of two or more kinds thereof. Such a method is preferred that an aqueous coating liquid containing the binder dispersed in water is prepared and coated. In this case, the proportion of water in the solvent is preferably 60% by mass or more, and more preferably 80% by mass or more.

The white layer is preferably formed by coating.

The fact that the polymer layer is such a one that is formed by coating may be confirmed by determining that the residual solvent amount of the polymer sheet is 1,000 ppm or less based on the total polymer layer. The residual solvent amount of the polymer sheet based on the total polymer layer is more preferably 500 ppm or less, and particularly preferably 100 ppm or less.

The thickness of the white layer is preferably 30 μm or less, more preferably from 1 to 20 μm, particularly preferably from 1.5 to 10 μm, and still particularly preferably from 2 to 8 μm. When the thickness is 1 μm or more, the reflectance may be sufficiently exhibited, and when the thickness is 30 μm or less, the surface shape may be prevented from being deteriorated, and the adhesion to the sealant before and after undergoing hygrothermal conditions may be improved.

Additional Functional Layers

The polymer sheet of the invention may have additional functional layers in addition to the polymer support, the weather resistant layer and the white layer. Examples of the additional layers provided include an undercoating layer.

The polymer sheet of the invention may have an undercoating layer that is disposed between the polymer support and the white layer and contains at least one kind of a polymer selected from a polyolefin resin, an acrylic resin and a polyester resin.

The thickness of the undercoating layer is preferably 2 μm or less, more preferably from 0.05 to 2 μm, and further preferably from 0.1 to 1.5 μm. When the thickness is 2 μm or less, the surface shape may be favorably maintained. When the thickness is 0.05 μm or more, the necessary adhesion may be ensured.

The undercoating layer preferably contains at least one kind of a polymer selected from a polyolefin resin, an acrylic resin and a polyester resin.

Examples of the polyolefin resin include a polymer formed of polyethylene and acrylic acid or methacrylic acid. Examples of the polyolefin resin also include commercially available products, and examples thereof include Arrowbase SE-1010, SE-1013N, SD-1010, TC-4010 and TD-4010 (all produced by Unitika Ltd.), Hitec S3148, S3121, and S8512 (all produced by TOHO Chemical Industry Co., Ltd.), and Chemipearl S-120, S-75N, V100 and EV210H (all produced by Mitsui Chemicals, Inc.).

Preferred examples of the acrylic resin include polymers containing polymethyl methacrylate, polyethyl acrylate and the like. Examples of the acrylic resin also include commercially available products, and preferred examples thereof include AS-563A (produced by Daicel Finechem Ltd.).

Preferred examples of the polyester resin include polyethylene terephthalate (PET) and polyethylene-2,6-naphthalate (PEN). Examples of the polyester resin also include commercially available products, and preferred examples thereof include Vylonal MD-1245 (produced by Toyobo Co., Ltd.).

Among these, an acrylic resin and a polyolefin resin are preferably used from the standpoint of ensuring the adhesion between the polyester support and the white layer. The polymers may be used solely or as a combination of two or more kinds thereof, and in the case where two or more kinds thereof are used in combination, a combination of an acrylic resin and a polyolefin resin is preferred.

Solar Cell Module

The solar cell module of the invention is constituted by providing the polymer sheet of the invention having been described, as a back protective sheet for a solar cell. The solar cell module of the invention uses the polymer sheet of the invention having been described, and the back protective sheet for a solar cell having less surface shape defects is recognized, thereby providing a solar cell module having less appearance failures.

The polymer layer formed by coating to have the structure of the polymer sheet of the invention has a high film strength, is excellent in resistance to damages, such as scratching and abrasion, and is excellent in light resistance, heat resistance and humidity resistance. According thereto, the solar cell module of the invention exhibits excellent weather resistance and exhibits stable electric power generation capability for a prolonged period of time.

In the description herein, the cell part having a laminated structure (transparent front substrate)/(device structure), in which the transparent substrate is disposed on the solar light incident side, and the device structure is disposed thereon, is referred to as a cell substrate.

Specifically, the solar cell module of the invention contains a transparent substrate, on which solar light is

incident (i.e., a front substrate, such as a glass substrate), a device structure containing a solar cell device and a sealant for sealing the solar cell device, which is provided on the substrate, and the back protective sheet for a solar cell of the invention, which is disposed on the opposite side to the side where the substrate of the device structure is disposed, and thus has a laminated structure (transparent front substrate)/(device structure)/(back sheet). Specifically, the device structure having a solar cell device converting light energy of solar light to electric energy is disposed between the transparent front substrate disposed on the side, on which solar light is directly incident, and the back sheet for a solar cell of the invention having been described, and the device structure including a solar cell device (such as a solar cell) is sealed and adhered between the front substrate and the back sheet by using a sealant, such as an ethylene-vinyl acetate (EVA) material.

For the other members than the solar cell module, the solar cell and the back protective sheet for a solar cell, details thereof are described, for example, in Taiyoko Hatsuden System Kosei Zairyo (Constitutional Materials for Solar Light Power Generation Systems) (supervised by E. Sugimoto, Kogyo Chosakai Publishing Co., Ltd. (2008)).

The transparent substrate may have light transparency that enables transmission of solar light, and may be appropriately selected from substrates that transmit solar light. From the standpoint of the electric power generation efficiency, a substrate having a higher light transmittance is preferred, and preferred examples of the substrate include a glass substrate and a transparent resin substrate, such as an acrylic resin.

Examples of the solar cell device used include various known solar cell devices including a silicon solar cell device, such as single crystal silicon, polycrystalline silicon and amorphous silicon, and a III-V Group or II-VI Group compound semiconductor solar cell, such as copper-indium-gallium-selenium, copper-indium-selenium, cadmium-tellurium and gallium-arsenic.

## Example

The invention will be described more specifically with reference to examples below. The materials, the amounts used, the ratios, the contents of processes, the procedures of processes, and the like in the examples shown below may be appropriately changed unless they deviate from the substance of the invention. Accordingly, the scope of the invention is not construed as being limited to the specific examples shown below. The "part" is based on mass unless otherwise indicated.

### Example 1

#### Material Composition and Characteristics of Polymer Sheet

A polymer sheet having a material composition shown in Table 1 shown later was produced and evaluated for the characteristics (optical density) thereof.

#### Production of Polymer Support

(1) Synthesis of Polyester

A polyester resin having an intrinsic viscosity IV of 0.80 and a carboxyl group content AV of 14 was synthesized according to the method described in Example 1 in JP-A-2011-208125.

(2) Production of Polymer Support in Film Form

The polyester resin was melt-extruded at 280°C from a twin-screw extruder and cast on a metal drum to produce an unstretched base film having a thickness of approximately 2.5 mm. Thereafter, the base film was stretched in MD (machine direction) 3.4 times at 90°C. The base film was further stretched in TD (transverse direction) 4.5 times at 120°C, subjected to a heat treatment at a film surface temperature of 200°C for 15 seconds, and then subjected to thermal relaxation of 5% and 11% in MD and TD, respectively, at 190°C. Thus, a biaxially stretched polyethylene terephthalate substrate having a thickness of 250 μm (hereinafter referred to as a polymer support) was provided.

#### Formation of White Layer

(1) Preparation of Titanium Dioxide Dispersion

Titanium dioxide was dispersed to an average particle diameter of 0.42 μm with a Dynomill dispersing equipment to prepare a titanium dioxide dispersion liquid. The average particle diameter of titanium dioxide was measured with

Microtrac FRA, produced by Honeywell, Inc.
Composition of Titanium Dioxide Dispersion Liquid Titanium dioxide 455.8 parts by mass
(Taipake CR-95, produced by Ishihara Sangyo Kaisha, Ltd., powder)
PVA aqueous solution 227.9 parts by mass
(PVA-105, produced by Kuraray Co., Ltd., concentration: 10% by mass)
Dispersant 5.5 parts by mass
(Demol EP, produced by Kao Corporation, concentration: 25% by mass)
Distilled water 310.8 parts by mass

(2) Preparation of Coating Liquid for forming White Layer

The components of the following composition were mixed in the order shown below to prepare a coating liquid for forming a white layer.
Composition of Coating Liquid for forming White Layer Titanium dioxide dispersion liquid shown above 298.5 parts by mass
Polyolefin binder 568.7 parts by mass
(Arrow Base SE-1010, produced by Unitika Ltd., concentration: 20% by mass) Nonionic surfactant 23.4 parts by mass (Naroacty CL95, produced by Sanyo Chemical Industries, Ltd., concentration 1% by mass)
Oxazoline crosslinking agent 58.4 parts by mass
(Epocros WS-700, produced by Nippon Shokubai Co., Ltd., concentration: 25% by mass)
Distilled water 51.0 parts by mass

(3) Formation of White Layer

The resulting coating liquid for forming a white layer was coated on the polymer support to a binder coated amount of 4.7 g/$m^2$ and a titanium dioxide coated amount of 5.6 g/$m^2$ and then dried at 170°C for 2 minutes, thereby forming a white layer having a thickness of 5 μm.

Formation of Weather Resistant Layer containing Silicon-Acrylic Hybrid Resin

(1) Preparation of Coating Liquid for forming Weather Resistant Layer containing Silicon-Acrylic Hybrid Resin

The components of the following composition were mixed in the order shown below to prepare a coating liquid for forming a weather resistant layer containing a silicone-acrylic hybrid resin, which was an organic-inorganic hybrid resin, as the polymer binder, carbon black as the colorant, and titanium dioxide as the scattering particles.
Composition of Coating Liquid for forming Weather Resistant Layer
Silicone binder 381.7 parts by mass
(Ceranate WSA1070, produced by DIC Corporation, silicone-acrylic hybrid polymer, polysiloxane structural unit: ca. 30%, concentration: 38% by mass)
Nonionic surfactant 13.1 parts by mass
(Naroacty CL95, produced by Sanyo Chemical Industries, Ltd., concentration 1% by mass)
Oxazoline crosslinking agent 105.1 parts by mass
(Epocros WS-700, produced by Nippon Shokubai Co., Ltd., concentration: 25% by mass)
Carbon black aqueous dispersion liquid 1.38 parts by mass (MF-5630 Black, produced by Dainichiseika Colour & Chemicals Mfg. Co., Ltd., concentration: 31.5% by mass)

Distilled water 15.3 parts by mass
Titanium dioxide dispersion liquid shown above (common to the white layer) 483.4 parts by mass

(2) Formation of Weather Resistant Layer containing Silicon-Acrylic Hybrid Resin

The surface of the polymer support opposite to the side where the white layer was formed (hereinafter referred to as a back surface side) was subjected to a corona treatment under the following conditions.

Gap clearance between electrode and dielectric roll: 1.6 mm
Treatment frequency: 9.6 kHz
Treatment speed: 20 m/min
Treatment intensity: 0.375 kV•A•min/$m^2$

The coating liquid for forming a weather resistant layer containing the silicone-acrylic hybrid resin was coated on the corona-treated surface on the back surface side of the polymer support to a binder coated amount of 5.1 g/$m^2$ and a titanium dioxide coated amount of 7.6 g/$m^2$ and then dried at 175°C for 2 minutes, thereby forming a weather resistant layer having a thickness of 10 μm containing the silicone-acrylic hybrid resin.

The polymer sheet of Example 1 was thus produced, which had the white layer provided on one surface of the polymer support, and the weather resistant layer containing the polymer binder, the colorant and the scattering particles provided on the opposite surface to the white layer.

Characteristics (Optical Density)

The polymer film of Example 1 was measured for a visual density by using a color densitometer, X-rite 310TR (produced by X-rite GmbH). The results obtained are shown in Table 1 below.

(1) Visual Transmittance

The polymer sheet was mounted on the color densitometer and measured for transmission visual density, and the visual transmission was calculated according to the following expression.

$$\text{visual transmittance (\%)} = 100/10^{\text{(transmission visual density)}}$$

(2) Visual Reflectance

The polymer sheet was placed on black paper and measured for reflective visual density on both surfaces of the polymer sheet, and the visual reflectance on both surfaces of the polymer sheet was calculated by using the reflective visual density according to the following expression.

$$\text{visual reflectance (\%)} = 100/10^{\text{(transmission reflective density)}}$$

Also, a difference in the visual reflectances of the front and back surfaces of the polymer sheet was calculated based on the visual reflectances of the surface A side (weather resistant layer) and the surface B side (white layer side) of the polymer sheet.

(3) Visual Absorbance

The polymer sheet was mounted on the color densitometer and measured for transmission visual density, and the visual absorbance was calculated according to the following expression. In the case where the visual reflectance was different between both the surfaces, the smaller value was used.

$$\text{visual absorbance} = 100 - \text{visual transmittance} - \text{visual reflectance (\%)}$$

Examples 2 to 7 and Comparative Examples 1 to 3

Polymer sheets of Examples 2 to 7 and Comparative Examples 1 to 3 were produced in the same manner as in Example 1 except that the amounts of carbon black and titanium dioxide added in the coating liquid for forming a weather resistant layer in Example 1 were changed as shown in Table 1, and were measured for characteristics (optical density).

Example 8

A polymer sheet of Example 8 was produced in the same manner as in Example 1 except that the silicone-acrylic hybrid resin in the coating liquid for forming a weather resistant layer was changed to a fluorine resin (Obbligato

SW0011F, produced by AGC Coat-tech Co., Ltd., concentration: 36% by mass), which was an organic polymer, and was measured for characteristics (optical density).

Example 9

A polymer sheet of Example 9 was produced in the same manner as in Example 1 except that the carbon black aqueous dispersion liquid in the coating liquid for forming a weather resistant layer was changed to a Quinacridone Red aqueous solution (AF Red E-17, produced by Dainichiseika Color & Chemicals Mfg. Co., Ltd., concentration: 40%), and was measured for characteristics (optical density).

Example 10

A polymer sheet of Example 10 was produced in the same manner as in Example 1 except that the titanium dispersion liquid in the coating liquid for forming a weather resistant layer was changed to a hollow particle aqueous solution (Ropaque OP-84J, produced by Rohm & Haas Corporation, concentration: 43%), and was measured for characteristics (optical density).

Example 11

A polymer sheet of Example 11 was produced in the same manner as in Example 1 except that in the production of the polymer support in a film form in Example 1, 15% by mass with respect to the mass of the polyester of titanium dioxide (Taipake CR-95, produced by Ishihara Sangyo Kaisha, Ltd., powder) and 0.053% by mass with respect to the mass of the polyester of carbon black (Carbon Black MA100, produced by Mitsubishi Chemical Corporation, powder) were added to produce a gray colored biaxially stretched polyethylene terephthalate substrate, and the weather resistant layer was not coated, and was measured for characteristics (optical density).

Comparative Example 4

A polymer sheet of Comparative Example 4 was produced in the same manner as in Example 11 except that carbon black was not added to the polymer support in a film form, and was measured for characteristics (optical density).

Comparative Example 5

A commercially available back protective sheet for a solar cell having a laminated structure (fluorine film)/(PET film) /(fluoride film) (Icosolar 2442, produced by Nippon Rika Isovolta Co., Ltd.) was measured for characteristics (optical density) and compared to the polymer sheets of the invention.

Comparative Example 6

A commercially available back protective sheet for a solar cell having a laminated structure (EVA film)/(PET film)/(modified fluorine film) (Scotchshield 17T, produced by 3M Company) was measured for characteristics (optical density) and compared to the polymer sheets of the invention.

Evaluation of Polymer Sheet

The polymer sheets produced in Examples and Comparative Examples were evaluated in the following manners. The evaluation results are shown in Table 1.

Visual Recognition of Surface Shape Defects

The polymer sheets of Examples and Comparative Examples each having a size of 1 m square each were viewed over light in a room with a brightness of 10,000 lux, and the visual recognition of surface shape defects was evaluated by 5 grades according to the following evaluation standard. The surface shape defect in this evaluation means fisheyes or repellency with a diameter of 1 mm or more confirmed.

Evaluation Standard

5: The surface shape defects were visually recognized within 30 seconds.
4: The surface shape defects were visually recognized in less than 60 seconds.
3: The visual recognition of the surface shape defects required 60 seconds or more.
2: The visual recognition of the surface shape defects required 5 minutes or more.
1: The surface shape defects were unable to be recognized visually.

Discrimination of Front and Back Surfaces

The polymer sheets of Examples and Comparative Examples each having a size of 1 m square each were viewed over light in a room with a brightness of 10,000 lux, and the discrimination of the front and back surfaces was evaluated by 5 grades according to the following evaluation standard.

Evaluation Standard

5: The front and back surfaces were discriminated within 30 seconds.
4: The front and back surfaces were discriminated in less than 60 seconds.
3: The discrimination of the front and back surfaces required 60 seconds or more.
2: The discrimination of the front and back surfaces required 5 minutes or more.
1: The front and back surfaces were unable to be discriminated visually.

Evaluation of Solar Cell Module

Production of Solar Cell Module

The polymer sheets of Examples and Comparative Examples were subjected to a visual examination for surface shape in a room with a brightness of 10,000 lux in advance. Thereafter, the portion having the surface shape defects thus visually determined was removed. Toughened glass having a thickness of 3 mm, an EVA sheet (SC50B, produced by Mitsui Chemicals Fabro, Inc.), a crystalline type solar cell (1 m in length and 2 m in width), an EVA sheet (SC50B, produced by Mitsui Chemicals Fabro, Inc.) and the polymer sheet of Examples or Comparative Examples were laminated in this order to make the white layer of the polymer sheet in direct contact with the EVA sheet, and hot-pressed with a vacuum laminator (vacuum laminator, produced by Nisshinbo Co., Ltd.) to adhere to the EVA sheet, thereby producing a crystalline type solar cell module. The adhesion was performed in the following manner.

Adhesion Method

By using a vacuum laminator, the assembly was provisionally adhered by vacuuming at 128°C for 3 minutes and pressing for 2 minutes. Thereafter, the assembly was adhered in a dry oven at 150°C for 30 minutes.

Evaluation of Appearance Failure Rate

The resulting crystalline type solar cell (1 m in length and 2 m in width) was visually examined for the appearance thereof in a room with a brightness of 10, 000 lux, and evaluated by 5 grades according to the following evaluation standard.
The solar cell module thus produced was allowed to stand under environmental conditions of 120°C and 100%RH for 120 hours, then visually examined for the appearance thereof in a room with a brightness of 10, 000 lux, and evaluated by 5 grades according to the following evaluation standard.

Evaluation Standard

5: No appearance failure was found.
4: An appearance failure having a size of 1 mm or more was not found, and one or less appearance failure having a size of less than 1 mm was found.
3: An appearance failure having a size of 1 mm or more was not found, and 3 or less appearance failures having a size of less than 1 mm were found.
2: One or more appearance failures having a size of 1 mm or more were found.

1: One or more appearance failures having a size of 1 mm or more were found, and 3 or more appearance failures having a size of less than 1 mm were found.

Table 1

| | Material composition and characteristics of polymer sheet | | | | | | | | | | | |
|---|---|---|---|---|---|---|---|---|---|---|---|---|
| | Polymer support | | | | | Weather resistant layer | | | | | White layer | W2/W1 |
| | Organic Polymer | Scattering particles | | Colorant | | Polymer | Scattering particles | | Colorant | | Kind of white pigment | |
| | | Kind | Mass ratio to organic polymer (PET) | Kind | Mass ratio to organic polymer (PET) | | Kind | Mass ratio to polymer | Kind | Mass ratio to polymer | | |
| | - | - | % by mass | - | % by mass | - | - | % by mass | - | % by mass | - | - |
| Example 1 | PET | - | - | - | - | Si latex | $TiO_2$ | 160 | CB | 0.300 | $TiO_2$ | 533 |
| Example 2 | PET | - | - | - | - | Si latex | $TiO_2$ | 160 | CB | 0.084 | $TiO_2$ | 1,905 |
| Example 3 | PET | - | - | - | - | Si latex | $TiO_2$ | 160 | CB | 0.054 | $TiO_2$ | 2,963 |
| Example 4 | PET | - | - | - | - | Si latex | $TiO_2$ | 160 | CB | 0.034 | $TiO_2$ | 4,706 |
| Example 5 | PET | - | - | - | - | Si latex | $TiO_2$ | 500 | CB | 0.028 | $TiO_2$ | 17,857 |
| Example 6 | PET | - | - | - | - | Si latex | $TiO_2$ | 80 | CB | 0.613 | $TiO_2$ | 131 |
| Example 7 | PET | - | - | - | - | Si latex | $TiO_2$ | 80 | CB | 0.122 | $TiO_2$ | 656 |
| Example 8 | PET | - | - | - | - | F latex | $TiO_2$ | 160 | CB | 0.084 | $TiO_2$ | 1,905 |
| Example 9 | PET | - | - | - | - | Si latex | $TiO_2$ | 160 | PV-19 | 0.160 | $TiO_2$ | 1,000 |
| Example 10 | PET | - | - | - | - | Si latex | hollow particles | 500 | CB | 0.084 | $TiO_2$ | 5,952 |
| Example 11 | PET | $TiO_2$ | 15 | CB | 0.053 | no weather resistant layer | | | | | $TiO_2$ | 283 |
| Comparative Example 1 | PET | - | - | - | - | Si latex | $TiO_2$ | 160 | - | - | $TiO_2$ | - |
| Comparative Example 2 | PET | - | - | - | - | Si latex | $TiO_2$ | 160 | CB | 0.012 | $TiO_2$ | 13,333 |
| Comparative Example 3 | PET | - | - | - | - | Si latex | $TiO_2$ | 10 | CB | 0.082 | $TiO_2$ | 122 |
| Comparative Example 4 | PET | $TiO_2$ | 15 | - | - | no weather resistant layer | | | | | $TiO_2$ | - |
| Comparative Example 5 | Icosolar 2442, Isovolta Co., Ltd. | | | | | | | | | | | |
| Comparative Example 6 | Scotchshield 17T, 3M Company | | | | | | | | | | | |

(continued)

Table 1 (continued)

| | Material composition and characteristics of polymer sheet | | | | | Evaluation of polymer sheet | | Solar cell module | |
|---|---|---|---|---|---|---|---|---|---|
| | Characteristics (visual density) | | | | | | | Evaluation of appearance failure | |
| | Visual transmittance | Visual reflectance | | | Visual absorbance | Visual recognition of surface shape defects | Discrimination of front and back surfaces | Before durability test | After durability test |
| | | Surface A (weather resistant layer) | Surface B (white layer) | Difference in reflectance between front and back surfaces | | | | | |
| | % | % | % | % | % | - | - | - | - |
| Example 1 | 6.9 | 45.7 | 56.2 | 10.5 | 47.4 | 3 | 4 | 5 | 3 |
| Example 2 | 13.8 | 60.3 | 67.6 | 7.4 | 25.9 | 5 | 4 | 5 | 5 |
| Example 3 | 15.5 | 66.1 | 70.8 | 4.7 | 18.4 | 5 | 3 | 5 | 5 |
| Example 4 | 18.8 | 69.2 | 72.4 | 3.3 | 12.0 | 4 | 3 | 5 | 4 |
| Example 5 | 6.3 | 81.3 | 91.2 | 9.9 | 12.4 | 5 | 4 | 5 | 5 |
| Example 6 | 31.3 | 28.2 | 47.9 | 19.7 | 40.5 | 3 | 5 | 5 | 3 |
| Example 7 | 28.8 | 55.0 | 64.6 | 9.6 | 16.2 | 3 | 4 | 5 | 3 |
| Example 8 | 13.2 | 58.9 | 69.2 | 10.3 | 27.9 | 5 | 4 | 5 | 5 |
| Example 9 | 14.3 | 58.9 | 69.2 | 10.3 | 26.8 | 4 | 4 | 5 | 4 |
| Example 10 | 13.6 | 58.9 | 69.2 | 10.3 | 27.5 | 4 | 4 | 5 | 4 |
| Example 11 | 5.1 | 83.2 | 93.3 | 10.1 | 11.7 | 5 | 4 | 5 | 5 |
| Comparative Example 1 | 21.9 | 75.9 | 75.9 | 0.0 | 2.2 | 1 | 1 | 3 | 1 |
| Comparative Example 2 | 20.0 | 70.8 | 72.4 | 1.6 | 9.2 | 2 | 2 | 4 | 2 |
| Comparative Example 3 | 52.0 | 40.7 | 41.7 | 0.9 | 7.3 | 2 | 1 | 4 | 2 |
| Comparative Example 4 | 6.3 | 89.1 | 89.1 | 0.0 | 4.6 | 1 | 1 | 3 | 1 |
| Comparative Example 5 | 0.4 | 70.8 | 70.8 | 0.0 | 28.8 | 2 | 1 | 4 | 2 |
| Comparative Example 6 | 16.2 | 83.2 | 83.2 | 0.0 | 0.6 | 1 | 1 | 3 | 1 |

As shown in Table 1, it was found that in the polymer sheets of Examples 1 to 11, the surface shape defects were easily recognized. It was thus found that the use of the polymer sheets of Examples 1 to 11 prevented in advance

appearance failures of the solar cell module from occurring.

It was also found that the polymer sheets of Comparative Examples 1, 2, 4 and 6 were inferior in recognition of surface shape defects, and the solar cell modules produced by using the polymer sheets of Comparative Examples exhibited a high appearance failure rate.

It was found that the polymer sheet of Comparative Example 3, which had a visual transmittance that exceeded the upper limit defined in the invention and a visual absorbance that was lower than the lower limit defined in the invention, was inferior in visual recognition of surface shape defects, and the solar cell module produced by using the polymer sheet of Comparative Example 3 exhibited a high appearance failure rate.

It was found that the polymer sheet of Comparative Example 5, which had a visual transmittance that was lower than the lower limit defined in the invention, was inferior in visual recognition of surface shape defects, and the solar cell module produced by using the polymer sheet of Comparative Example 5 exhibited a high appearance failure rate.

It was also found that in the polymer sheets of Examples, the front and back surfaces thereof were easily discriminated.

Reference Sign List

1 white layer
3 layer containing binder, colorant and scattering particles (weather resistant layer)
12 polymer sheet of the invention (back protective sheet for solar cell module of the invention)
16 polymer support
22 sealant
20 solar cell device
24 transparent front substrate (toughened glass)
10 solar cell module

## Claims

**1.** A polymer sheet having a visual transmittance and a visual absorption that satisfy the following expressions (1) and (2):

$$5\% \leq \text{(visual transmittance)} \leq 50\% \quad (1)$$

$$10\% \leq \text{(visual absorption)} \leq 50\% \quad (2)$$

**2.** The polymer sheet according to Claim 1, which is a back protective sheet for a solar cell.

**3.** The polymer sheet according to Claim 1 or 2, wherein the polymer sheet contains a binder containing an organic polymer, an inorganic polymer or an organic-inorganic hybrid polymer, a colorant and scattering particles in one layer, and
the layer containing the binder, the colorant and the scattering particles has a content W1 of the colorant and a content W2 of the scattering particles that satisfy the following expression (3):

$$1{,}000 \leq W2/W1 \leq 30{,}000 \quad (3)$$

wherein W1 represents the content (% by mass) of the colorant with respect to the binder, and W2 represents the content (% by mass) of the scattering particles with respect to the binder.

**4.** The polymer sheet according to Claim 3, wherein the colorant is carbon black.

**5.** The polymer sheet according to Claim 3 or 4, wherein the scattering particles are titanium dioxide.

6. The polymer sheet according to any one of Claims 1 to 5, wherein the polymer sheet is a laminate having two or more layers.

7. The polymer sheet according to any one of Claims 1 to 6, wherein the polymer sheet further comprises a polymer support.

8. The polymer sheet according to any one of Claims 1 to 7, wherein the polymer sheet further comprises a white layer containing a white pigment.

9. The polymer sheet according to any one of Claims 1 to 8, wherein the polymer sheet has a difference in visual reflectance between front and back surfaces thereof of 3% or more.

10. A solar cell module comprising the polymer sheet according to any one of Claims 1 to 9 as a back protective sheet for a solar cell module.

Fig. 1

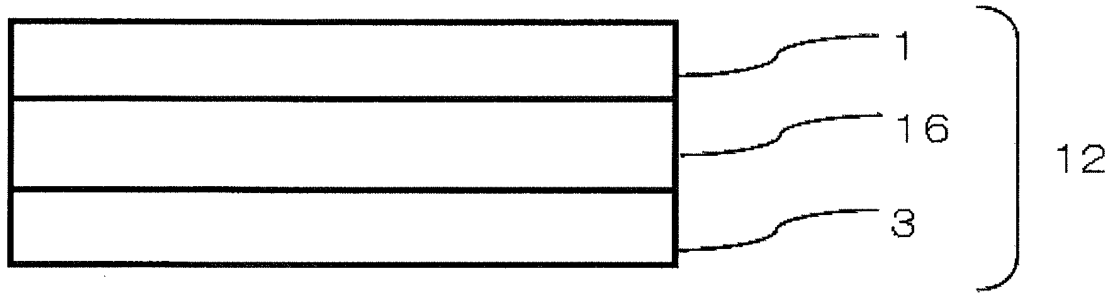


Fig. 2

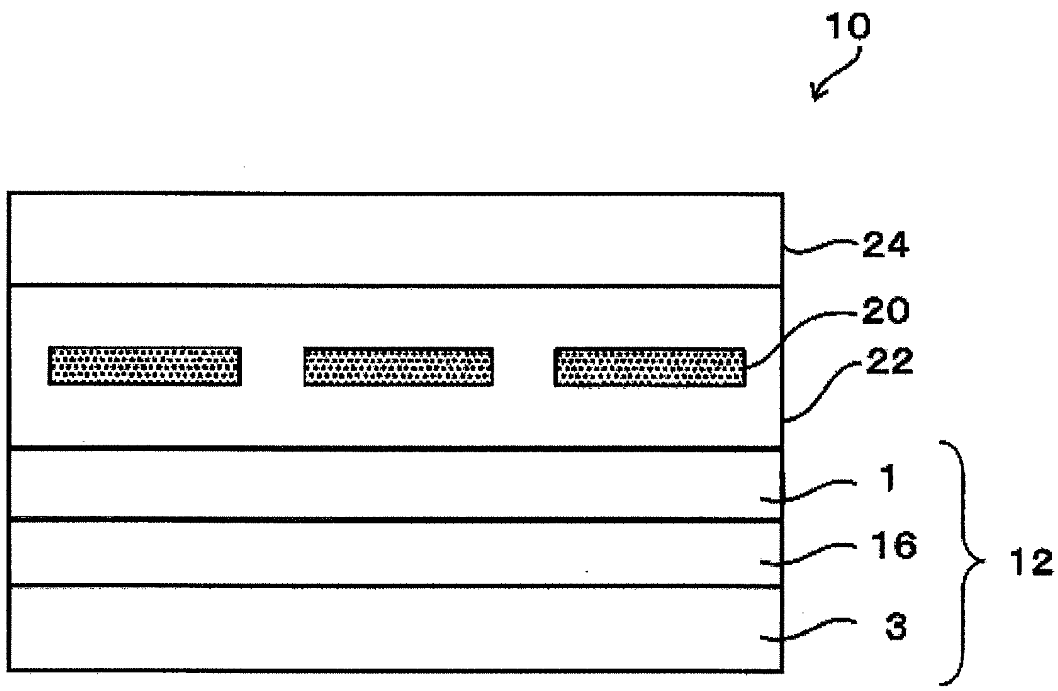

**INTERNATIONAL SEARCH REPORT**

International application No.
PCT/JP2013/058031

A. CLASSIFICATION OF SUBJECT MATTER
*C08J5/18*(2006.01)i, *B32B27/00*(2006.01)i, *B32B27/20*(2006.01)i, *C08K3/04*(2006.01)i, *C08K3/22*(2006.01)i, *C08L67/02*(2006.01)i, *H01L31/042*(2006.01)i

According to International Patent Classification (IPC) or to both national classification and IPC

B. FIELDS SEARCHED

Minimum documentation searched (classification system followed by classification symbols)
C08J5/18, B32B27/00, B32B27/20, C08K3/04, C08K3/22, C08L67/02, H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 10-508263 A (Deposition Technology, Inc.),<br>18 August 1998 (18.08.1998),<br>entire text<br>& WO 96/013379 A1 & US 5513040 A1 | 1,3-9<br>2,10 |
| X<br>A | JP 2009-216734 A (Achilles Corp.),<br>24 September 2009 (24.09.2009),<br>entire text<br>(Family: none) | 1,3-9<br>2,10 |
| X<br>A | WO 2010/047391 A1 (Mitsubishi Chemical Corp.),<br>29 April 2010 (29.04.2010),<br>entire text<br>& US 2011/0261443 A1 & EP 2361893 A1 | 1,3-9<br>2,10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 April, 2013 (05.04.13) | 16 April, 2013 (16.04.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No. PCT/JP2013/058031

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2000-52639 A (Unionchemicar Co., Ltd.), 22 February 2000 (22.02.2000), entire text (Family: none) | 1,3-9<br>2,10 |
| X<br>A | JP 2008-39960 A (Oike & Co., Ltd.), 21 February 2008 (21.02.2008), entire text (Family: none) | 1,3-9<br>2,10 |
| A | JP 2011-510849 A (Arkema France), 07 April 2011 (07.04.2011), entire text & WO 2009/101343 A1 & US 2011/0232735 A1 & EP 2237950 A | 2,10 |
| A | JP 2009-212432 A (Teijin DuPont Films Japan Ltd.), 17 September 2009 (17.09.2009), entire text (Family: none) | 2,10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010519742 A
- JP 2007150084 A
- JP 2006270025 A
- JP 2011029397 A
- JP 2011165967 A
- JP 2011184488 A
- JP 8301198 B
- JP 2543624 B
- JP 3335683 B
- JP 3717380 B
- JP 3897756 A
- JP 3962226 B
- JP 3979866 B
- JP 3996871 B
- JP 4000867 B
- JP 4053837 B
- JP 4127119 B
- JP 4134710 B
- JP 4159154 B
- JP 4269704 B
- JP 4313538 B
- JP 2621563 B
- JP 3121876 B
- JP 3136774 B
- JP 3603585 B
- JP 3616522 B
- JP 3617340 B
- JP 3680523 B
- JP 3717392 B
- JP 4167159 B
- JP 2009052011 A
- JP 2003231722 A
- JP 2002020409 A
- JP 9194538 A
- JP 2009132887 A
- JP 2009235278 A
- JP 2011208125 A


### Non-patent literature cited in the description


- **H.A. PHOL.** *Anal. Chem.,* 1954, vol. 26, 2145
- **E. SUGIMOTO.** Taiyoko Hatsuden System Kosei Zairyo. Kogyo Chosakai Publishing Co., Ltd, 2008